# FASCICULE DE BREVET EUROPEEN

(11) **EP 2 065 486 B1**
(45) Date de publication et mention de la délivrance du brevet: **27.02.2013**
(21) Numéro de dépôt: 08291113.2
(22) Date de dépôt: 27.11.2008
(51) Int. Cl.: C23C 14/34

(54) **Procédé de dépôt de nanoparticules métalliques par dépôt physique en phase vapeur**
Verfahren zur Beschichtung mit Metallnanopartikeln durch physikalische Beschichtung aus der Dampfphase
Method of depositing metal nanoparticles by physical deposition in vapour phase

(30) Priorité: 30.11.2007 FR 0708374
(43) Date de publication de la demande: 03.06.2009
(73) Titulaire: Commissariat à l'Énergie Atomique et aux Énergies Alternatives, 75015 Paris (FR)
(72) Inventeur: Bedel, Laurent, 38950 Quaix en Chartreuse (FR); Emieux, Fabrice, 38340 Voreppe (FR); Mailley, Sophie, 38730 Le Pin (FR); Taupeau, Anthony, 33600 Pessac (FR)
(74) Mandataire: Noel, Chantal Odile

(56) Documents cités:
- DE-A1- 10 342 258
- US-A- 5 879 827
- TERAUCHI S ET AL: "Fabrication of Au Nanoparticles by radio-frequency magnetron sputtering" NANOSTRUCTURED MATERIALS, ELSEVIER, NEW YORK, NY, US, vol. 5, no. 1, 1 janvier 1995 (1995-01-01), pages 71-78, XP004024877 ISSN: 0965-9773
- G.M. CHOW AND A.S. EDELSTEIN: "Sputter Deposition of Nanocrystals and Nanocomposites" NANOSTRUCTURED MATERIALS, vol. 1, no. 1, 1992, pages 107-111, XP002483363
- A. CAILLARD ET AL: "Plasma based platinum nanoaggregates deposited on carbon nanofibres improve fuel cell efficiency" APPLIED PHYSICS LETTERS, vol. 90, 1 juin 2007 (2007-06-01), pages 1-3, XP002483364
- M. YEADON ET AL: "Sintering of Silver and Copper Nanoparticles on (001) Copper IObserved by in-situ Ultrahigh Vacuum Transmission Electron Microscopy" NANOSTRUCTURED MATERIALS, vol. 10, no. 5, 1998, pages 731-739, XP002483365

## Description

La présente Invention est relative à un procédé de dépôt de nanoparticules métalliques par dépôt physique en phase vapeur à la surface d'un substrat pouvant être sensible thermiquement, à une pression de l'ordre de quelques dizaines de Pascals, ainsi qu'aux substrats obtenus en mettant en oeuvre ce procédé et à leurs applications.

Le domaine technique de l'Invention peut être défini de manière générale comme celui de la préparation d'un revêtement nanoparticulaire à la surface d'un substrat ou d'un support sensible thermiquement.

Ces matériaux comportant un revêtement nanoparticulaire trouvent généralement leur application dans les domaines de la microélectronique (films conducteurs, isolants ou semi-conducteurs), de la mécanique (dépôts de couches anti-usure et anti-corrosion), de l'optique (capteurs de rayonnements), et surtout de la catalyse, notamment pour la protection de l'environnement.

Les matériaux qui sont déposés sous la forme de particules à l'échelle du nanomètre ont une réactivité plus importante que les matériaux massifs. Lorsqu'ils sont appliqués à la surface d'un substrat, ces métaux lui confèrent des propriétés particulières qui sont essentielles pour de nombreuses applications telles que le dépôt de catalyseur pour les piles à combustible ou pour catalyser des réactions chimiques, la fabrication de surfaces à propriétés optiques spécifiques ou à propriété antibactériennes,

Dans ce domaine, les métaux comme le platine, le rhodium, le nickel et l'argent font l'objet de nombreuses recherches.

Plusieurs types de procédés permettant de recouvrir la surface d'un substrat de ce type de particules de métal ont déjà été proposés. Deux grandes voies sont généralement explorées.

La première voie consiste à manipuler des nanoparticules et à les déposer sur une surface et fait appel par exemple à des techniques telles que l'imprégnation et l'électrodéposition qui figurent parmi les procédés les plus anciens.

La seconde voie, plus récente, consiste à former les nanoparticules directement sur le support à revêtir. Elle comprend notamment les procédés dits de dépôt physique en phase vapeur ("Physical Vapour Deposition" ou PVD en anglais) ainsi que les procédés dits de dépôts chimiques en phase vapeur ("Chemical Vapour Deposition" ou CVD en anglais).

Des travaux utilisant les procédés CVD ont montré la capacité d'immobilisation de particules nanométriques sur des substrats plans ou poreux. A cet égard, la demande internationale WO 2006/070130 rapporte par exemple la formation de nanoparticules d'un métal ou d'un alliage dudit métal par CVD à partir d'une source de précurseurs de type organométalliques. Les nanoparticules sont alors formées par décomposition thermique du précurseur à une température élevée, de l'ordre de 200 à 300°C voire plus, selon un procédé dans lequel le temps de dépôt varie entre quelques minutes et 90 minutes. En CVD dite "classique" ou "thermique", la température du substrat fournit l'énergie d'activation nécessaire à la réaction hétérogène à l'origine de la croissance du matériau déposé. Ces températures élevées ne sont cependant pas compatibles avec les substrats à recouvrir qui sont sensibles thermiquement.

Le dépôt physique en phase vapeur (PVD) est une méthode de dépôt sous vide de films minces. Les principales méthodes de PVD sont la pulvérisation cathodique (également connue sous le nom de "Sputtering" en anglais) et l'évaporation.

La pulvérisation cathodique est une technique qui autorise la synthèse de plusieurs matériaux à partir de la condensation d'une vapeur métallique issue d'une source solide (matériau cible) sur un substrat. L'application d'une différence de potentiel entre la cible (servant de cathode) et les parois du réacteur au sein d'une atmosphère raréfiée permet la création d'un plasma froid, composé d'électrons, d'ions, de photons et de neutrons dans un état fondamental ou excité. Sous l'effet d'un champ électrique, les espèces positives du plasma sont attirées par la cathode (cible) et entrent en collision avec cette dernière. Elles communiquent alors leur quantité de mouvement, provoquant ainsi la pulvérisation des atomes de la cible sous forme de particules neutres qui se condensent sur le substrat (anode). La formation du dépôt sur le substrat, généralement sous la forme d'un film continu, s'effectue selon plusieurs mécanismes qui dépendent des forces d'interactions entre le substrat et le dépôt. La décharge est auto-entretenue par les électrons secondaires émis de la cible. En effet, ceux-ci, lors de collisions inélastiques, transfèrent une partie de leur énergie cinétique en énergie potentielle aux atomes du gaz résiduel (argon par exemple) qui peuvent s'ioniser.

Les techniques de dépôts par pulvérisation cathodique présentent l'avantage de pouvoir revêtir des substrats à température ambiante. Cette technique est donc particulièrement bien adaptée aux substrats sensibles thermiquement. Industriellement, les pressions de travail sont de l'ordre du Pascal (Pa) afin de garantir des vitesses de dépôt suffisantes. C'est ainsi qu'il a déjà été proposé, notamment par Ryan O'Hayre et al. (Journal of Power Sources, 2002, 109, 483-493) un procédé de dépôt de platine sur une résine copolymère à base de tétrafluoroéthylène sulfonaté connue sous la dénomination commerciale Nafion®, par pulvérisation cathodique à une pression de 0,68 Pa pour une puissance appliquée sur la cible de platine de l'ordre de 100 W. Pour un temps de dépôt très court (5 secondes), des microparticules de platine apparaissent sur le support en Nafion®, et au-delà, un film continu est ensuite formé. D'autres auteurs, Alvisi M. et al. (Surface & Coating Technology, 2005, 200, 1325-1329) ont étudié des dépôts de platine sur des électrodes à diffusion de gaz (GDL) à température ambiante, à une pression de 0,28 Pa et pour des densités de puissance de 1,23 W/cm². Dans ces conditions, le temps de dépôt, qui n'est pas indiqué par les Auteurs, doit être très court et ne permet pas de contrôler la teneur en platine. Un dépôt réalisé dans les mêmes conditions conduit, sur un support plan, à un film continu ; en effet, les particules de platine sont adjacentes et certaines ont déjà coalescé. Ainsi, par ces procédés, les dépôts se présentent sous la forme d'un film continu, l'étape de germination et de croissance des particules ne permettant pas de contrôler leur densité surfacique car la coalescence entre les particules se produit très rapidement.

D'autres auteurs, tels que Hahn H. et al. (J. Appl. Phys., 1990, 67(2), 1113-1115) ont utilisé le procédé de pulvérisation cathodique magnétron pour obtenir des poudres avec des cristaux de taille nanométrique. La pulvérisation cathodique magnétron met en oeuvre un dispositif magnétron, qui est constitué de deux aimants permanents de polarité inverse situés sous la cible. Cette technique permet d'augmenter la densité ionique au voisinage de la cible. Les aimants créent en effet un champ magnétique B parallèle à la surface de la cible et orthogonal au champ électrique E. La combinaison de ces deux champs donne naissance à des lignes de champ qui piègent les électrons secondaires. La force de Lorentz induite provoque un mouvement hélicoïdal des électrons augmentant ainsi leur trajectoire et, de ce fait, leur efficacité d'ionisation. L'effet magnétron permet donc d'entretenir la décharge pour de plus faibles pressions de travail, améliorant par conséquent la qualité des revêtements obtenus. Les auteurs Hahn H. *et al.,* signalent cependant que l'utilisation d'une pression élevée, c'est-à-dire comprise entre 100 Pa et 1000 Pa, est nécessaire pour pouvoir obtenir ce type de particules par ce procédé. La mesure de la taille des cristallites obtenues par ce procédé a été mesurée par diffractométrie de rayons X (DRX) mais les auteurs ne rapportent aucune observation de nanoparticules. Selon ce procédé, de plus fortes densités de puissance ont été utilisées (de l'ordre de 25 W/cm²), ce qui a pour inconvénient d'entraîner un réchauffement rapide du substrat qui est incompatible avec les substrats sensibles thermiquement. De plus dans les gammes de pressions utilisées, les particules générées pendant le procédé ne sont pas adhérentes car elles sont collectées par thermophorèse sur un doigt refroidi à l'azote liquide à l'intérieur d'un réacteur.

Terauchi S. et al. dans "Fabrication of Au nanoparticules by radio-frequency magnetron sputtering", Nanostructured materials, Elsevier, New York, NY, US, vol. 5, no. 1, 1 janvier 1995, pages 71-78, décrivent un procédé de dépôt de particules métalliques par pulvérisation cathodique à une pression comprise entre 60 et 300 mTorr.

Les particules métalliques obtenues ont une taille variable entre 3 et 12 nm et ne forment pas de film.

Les temps de pulvérisation cathodique utilisés varient entre 1 et 10 minutes.

Terauchi S. *et al*. enseigne également qu'augmenter le temps de pulvérisation cathodique n'augmente pas la taille des nanoparticules mais augmente la quantité de particules formées qui d'ailleurs ne se déposent pas toutes.

Il enseigne de plus qu'à une pression de 150 mTorr, la taille des nanoparticules diminue avec une augmentation de la pression.

C'est donc afin de remédier à l'ensemble de ces inconvénients et de pourvoir à un procédé de dépôt de nanoparticules qui soit compatible avec l'utilisation éventuelle de substrats sensibles thermiquement que les Inventeurs ont mis au point ce qui fait l'objet de la présente Invention.

Les Inventeurs se sont en effet fixés pour but de pourvoir à un nouveau procédé de dépôt de nanoparticules à la surface d'un substrat par dépôt physique en phase vapeur qui soit facile à mettre en oeuvre, adapté à l'utilisation de substrats sensibles thermiquement si on le souhaite et qui permette de contrôler la formation (taille) et la répartition des nanoparticules sur le substrat.

Au sens de la présente Invention, le mot "nanoparticule" définit des particules isolées les unes des autres et qui présentent une taille moyenne inférieure ou égale à 20 nm. La taille des particules est mesurée par analyse d'image à partir de photos prises par MEB. Ces photos sont ensuite binarisées et analysées. La taille moyenne est la moyenne arithmétique de la taille de toutes les particules apparentes sur les photos binarisées.

Ces buts sont atteints par le procédé qui fait l'objet de la présente Invention et va être décrit ci-après.

La présente Invention a donc pour objet un procédé de dépôt de nanoparticules métalliques par dépôt physique en phase vapeur, ledit procédé comportant au moins une étape de pulvérisation cathodique d'un matériau métallique cible en présence d'un gaz neutre à la surface d'un substrat, caractérisé par le fait que ladite étape de pulvérisation cathodique est réalisée dans une enceinte maintenue à une pression de 15 à 60 Pa, pendant une durée inférieure à 20 secondes.

Les Inventeurs ont en effet constaté que lorsque la pression est supérieure à 60 Pa, la décharge est moins stable et peu ou pas de nanoparticules sont déposées. A l'inverse, lorsque la pression est inférieure à 15 Pa, on obtient un film continu ou l'équivalent de particules coalescées et il n'est pas possible de contrôler la densité surfacique des nanoparticules.

Par ailleurs, pour des temps de dépôt supérieurs à 20 secondes, les nanoparticules commencent à coalescer pour conduire à un film mince.

De façon préférentielle, l'étape de pulvérisation cathodique est une pulvérisation cathodique magnétron.

Grâce au procédé conforme à l'Invention, il est possible de déposer sur la surface du substrat des nanoparticules métalliques ayant une taille moyenne contrôlée et comprise entre 2 et 20 nm environ. La densité des nanoparticules à la surface du substrat est contrôlée par la pression et le temps de dépôt. Il est ainsi possible d'obtenir des dépôts de particules métalliques non coalescents.

Selon une forme de réalisation préférée de l'Invention, le temps de dépôt est compris entre 2 et 20 secondes environ.

Lors de l'étape de pulvérisation, la pression au sein de l'enceinte est de préférence maintenue à une valeur allant de 20 à 40 Pa environ, préférentiellement de 30 Pa à 40 Pa environ.

Selon une forme de réalisation préférée de l'Invention, l'étape de pulvérisation est conduite avec une densité de puissance de décharge sur la cible métallique comprise entre 0,2 W/cm² et 5 W/cm² inclusivement et préférentiellement entre 0,5 et 1 W/cm² inclusivement, plus préférablement de 1 W/cm².

Selon une forme de réalisation avantageuse de l'Invention, le gaz neutre utilisé pendant l'étape de pulvérisation est choisi parmi les gaz rares et leurs mélanges. Les gaz rares (également appelés gaz nobles ou gaz inertes) correspondent aux éléments qui forment le huitième et dernier groupe du tableau périodique des éléments. Ce groupe comprend l'hélium, le néon, l'argon, le krypton, le xénon et le radon. Parmi ces gaz rares, l'argon est tout particulièrement préféré.

Selon le procédé conforme à la présente Invention, l'étape de pulvérisation est effectuée à une température basse, c'est-à-dire à une température du substrat inférieure ou égale à 100°C, cette température étant bien évidemment ajustée en fonction de la nature du substrat. De façon préférentielle, l'étape de pulvérisation est réalisée à température ambiante.

C'est là un avantage supplémentaire du procédé conforme à l'Invention grâce auquel il est possible de travailler sur des substrats sensibles thermiquement. Selon l'Invention, un substrat sensible thermiquement est un substrat qui se dégrade à basse température (inférieure à 150°C).

Le substrat sur lequel le dépôt des nanoparticules est réalisé peut aussi bien être un substrat poreux qu'un substrat dense, éventuellement sensible thermiquement. Ces substrats sont aussi divers que le verre, le silicium, les métaux, les aciers, les céramiques telles que l'alumine, la cérine et la zircone, les tissus, les zéolithes, les polymères, etc...

Au sein de l'enceinte de dépôt, la distance entre la cible et le substrat est de préférence comprise entre 20 et 100 mm inclusivement, et encore plus préférentiellement entre 40 et 60 mm inclusivement.

La nature des métaux constituant la cible métallique n'est pas critique. Ils peuvent en particulier être choisis en fonction des propriétés que l'on souhaite conférer au substrat sur lequel ils vont être déposés. Parmi les métaux pouvant constituer la cible métallique, on peut par exemple citer le platine, l'argent, l'or, le nickel, le palladium, le cuivre, le rhodium, l'iridium, le ruthénium, le chrome, le molybdène et leurs mélanges.

Selon l'invention, le procédé peut comporter plusieurs étapes successives de dépôts de nanoparticules utilisant des cibles métalliques de nature différente. Il est possible de déposer successivement, sur la surface d'un même substrat, des nanoparticules de différents métaux.

Dans un mode de mise en oeuvre particulièrement avantageux du procédé de l'invention, le substrat traverse l'enceinte de dépôt à une vitesse de défilement telle que le temps de dépôt est inférieur à 20 secondes, de préférence compris entre 2 et 10 secondes.

Ce procédé est également appelé procédé de dépôt « au défilé ». Il permet de couvrir de grandes surfaces. Dans ce procédé le temps de dépôt est contrôlé par le contrôle de la vitesse de défilement du substrat à recouvrir dans l'enceinte de dépôt, plus précisément par le contrôle de la vitesse de défilement du substrat devant la (ou les) cible(s) métallique(s) qui, elles, sont maintenues fixes.

L'invention décrit également un substrat susceptible d'être obtenu par la mise en oeuvre du procédé conforme à l'Invention et tel que défini précédemment, qui est constitué d'un support solide comportant au moins une surface sur laquelle est présente une couche de nanoparticules métalliques non coalescentes, lesdites nanoparticules ayant une taille moyenne inférieure ou égale à 20 nm.

Selon une forme de réalisation avantageuse, la taille moyenne des particules métalliques est comprise entre 2 et 10 nm inclusivement.

La densité des nanoparticules métalliques sur la surface du substrat est de préférence comprise entre 200 et 50 000 nanoparticules/µm², et encore plus préférentiellement entre 500 et 30 000 nanoparticules/µm².

Enfin, ces nanoparticules peuvent avantageusement être recouvertes par un film mince préférentiellement en polymère ou en un matériau métallique ou en céramique telle qu'un carbure ou un nitrure ou un oxyde d'un métal, par exemple du carbure de silicium, du carbure de tungstène, du carbure de bore, du carbure de zirconium, du nitrure de bore, du nitrure d'aluminium, du nitrure de silicium, du nitrure de titane, de l'oxyde de silicium et de l'oxyde de zirconium, mais pouvant aussi être en un matériau organique. Ce film peut être déposé par pulvérisation ("spray"), par peinture, par trempage ou bien encore par toute autre technique adaptée. La présence de ce film permet d'encapsuler le dépôt des nanoparticules et ainsi de protéger sa surface. Il peut également apporter une nouvelle fonction ou améliorer une fonction déjà existante dans le dépôt telle que par exemple la conductivité protonique, l'absorption de rayonnements, etc...

De part la nature chimique des nanoparticules métalliques déposées à leur surface, les substrats ainsi préparés peuvent présenter une large variété d'applications.

Ainsi lorsque la surface du substrat comporte des nanoparticules d'argent, ledit substrat possède des propriétés antibactériennes.

Un autre objet de la présente Invention est donc l'utilisation d'un substrat tel que défini ci-dessus, dans lequel les nanoparticules métalliques sont des nanoparticules d'argent, à titre de substrat antibactérien.

Ces substrats peuvent également servir de matériau d'électrode pour pile à combustible.

Enfin, lorsque les nanoparticules métalliques sont semiconductrices, le substrat peut être utilisé comme matériau photovoltaïque.

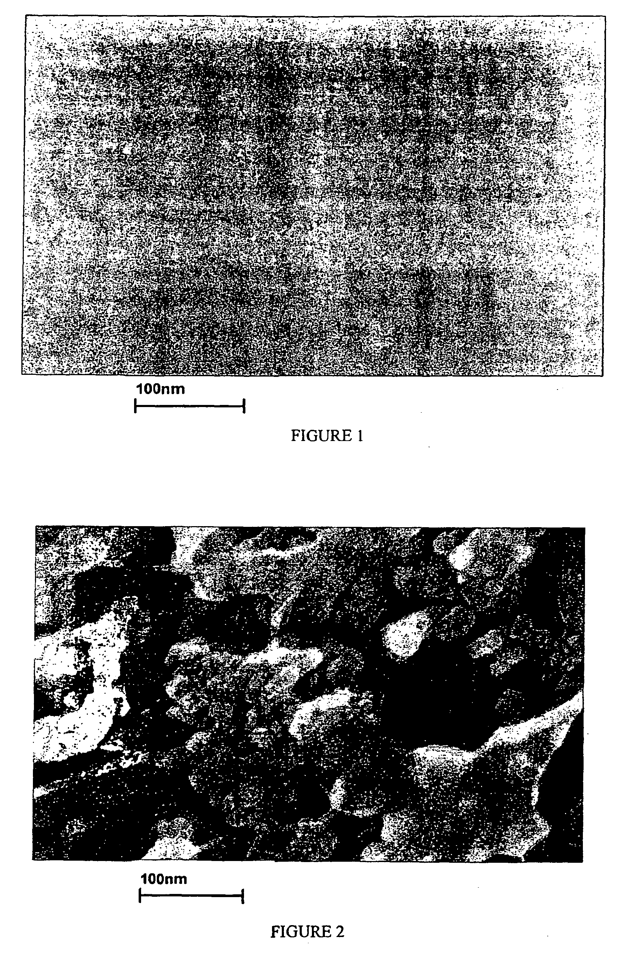

Outre les dispositions qui précèdent, l'Invention comprend encore d'autres dispositions qui ressortiront de la description qui va suivre, qui se réfère à des exemples de dépôt de nanoparticules de platine sur des supports de silicium ou sur des électrodes à diffusion de gaz et de dépôt de particules d'argent sur un support en Nafion®, ainsi qu'aux figures 1 à 3 annexées dans lesquelles :
- la figure 1 est une photographie en microscopie électronique à balayage (MEB), avec un grossissement x 5.10⁵, d'un substrat de silicium dont la surface a été recouverte par des nanoparticules de platine selon le procédé conforme à l'Invention;
- la figure 2 est une photographie en microscopie électronique à balayage (MEB), avec un grossissement x 5.10⁵, d'une électrode à diffusion de gaz dont la surface a été recouverte par des nanoparticules de platine selon le procédé conforme à l'Invention;
- la figure 3 est une photographie en microscopie électronique à balayage (MEB), avec un grossissement x 2.10⁵, d'un substrat en Nafion® dont la surface a été recouverte par des nanoparticules d'argent selon le procédé conforme à l'Invention ;
- la figure 4 est une photographie en microscopie électronique à balayage (MEB), avec un grossissement x 5.10⁵, d'un substrat de silicium dont la surface a été recouverte de nanoparticules de platine par le procédé selon l'invention « au défilé » ;
- la figure 5 est une photographie en microscopie électronique à balayage (MEB), avec un grossissement x 2.10⁵, d'un substrat de silicium dont la surface a été recouverte de nanoparticules d'argent par un procédé dans lequel la pression de l'enceinte était de 10 Pa ; et
- la figure 6 est une image binarisée prise en MEB-FEG (Field Emission Gun) avec un grossissement x500000 d'un substrat en tissu de carbone dont la surface a été recouverte de nanoparticules de platine par le procédé selon l'invention.

Il doit être entendu toutefois que ces exemples ne sont donnés qu'à titre purement illustratif de l'Invention dont ils ne constituent en aucune manière une quelconque limitation.

### EXEMPLES

Dans les exemples de réalisation qui vont être décrits ci-après, les dépôts ont été réalisés à l'aide d'un dispositif de PVD réalisé au laboratoire comprenant, de façon standard dans une enceinte, la cible et le substrat ainsi qu'un magnétron relié à une source de puissance.

### EXEMPLE 1 : PRÉPARATION DE NANOPARTICULES DE PLATINE SUR UN SUBSTRAT DE SILICIUM.

L'objectif de cet exemple est de démontrer que le procédé conforme à la présente Invention permet de préparer des nanoparticules de platine ayant une taille particulaire, c'est-à-dire une taille moyenne de particules, d'environ 2-3 nm.

On a réalisé trois dépôts de nanoparticules de platine sur un substrat de silicium. Les dépôts ont été réalisés à partir de la pulvérisation magnétron en courant pulsé d'une cible de platine (pureté 99,99%) en présence d'une atmosphère d'argon. Les conditions opératoires sont regroupées ci-dessous :
- Pression de l'enceinte : 30 Pa
- Densité de puissance de la décharge sur la cible : 1 W/cm²
- Caractéristiques des impulsions : Fréquence : 70 kHz Temps d'inversion de la polarisation ("Reverse Time") 4 µs
- Dimensions de la cible de platine 210 x 90 mm²
- Dimensions du substrat de silicium 50 x 50 mm²
- Distance substrat-cible 40 mm
- Temps de dépôt 3 s ; 5 s et 7 s
- Gaz argon
- Température ambiante

Pour chacun des trois temps de dépôt, la densité du dépôt des nanoparticules sur la cible était la suivante :
- Temps de dépôt de 3 s : 15 000 nanoparticules / µm² environ.
- Temps de dépôt de 5 s : 24 000 nanoparticules / µm² environ.
- Temps de dépôt de 7 s : 30 000 nanoparticules / µm² environ.

Ces résultats montrent que la densité des nanoparticules et la fraction surfacique sont proportionnelles au temps de dépôt.

Le substrat correspondant au temps de dépôt = 5 s a été caractérisé en microscopie électronique à balayage et est représenté sur la figure 1 annexée (grossissement x 5.10⁵). Sur cette figure, on observe des nanoparticules de platine ayant une taille moyenne voisine de 2-3 nm avec une densité particulaire d'environ 24 000/µm² et une fraction surfacique voisine de 25 % qui démontre bien que l'on n'obtient pas de film continu.

### EXEMPLE 2 : PRÉPARATION DE NANOPARTICULES DE PLATINE SUR UNE COUCHE DE DIFFUSION (GDL)

Le procédé de dépôt de particules de platine décrit ci-dessus à l'exemple 1 a également été reproduit sur une couche de diffusion (électrode à diffusion de gaz : GDL). Les conditions opératoires sont regroupées ci-dessous :
- Pression de l'enceinte : 30 Pa
- Densité de puissance de la décharge sur la cible : 1,5 W/cm²
- Caractéristiques des impulsions : * Fréquence : 70 kHz * Temps d'inversion de la polarisation 4 µs
- Dimensions de la cible de platine 210 x 90 mm²
- Nature de la GDL (substrat) E-Tek ®r vendu par la société BASF
- Dimensions de la GDL 50 x 50 mm²
- Distance substrat-cible 40 mm
- Temps de dépôt 5 s
- Gaz argon
- Température ambiante

La figure 2 est une photographie en microscopie électronique à balayage (grossissement x 5.10⁵) du substrat ainsi obtenu.

Sur cette figure, on observe la formation de nanoparticules de platine d'une taille moyenne voisine de 2-3 nm.

Ce dépôt a ensuite été recouvert par pulvérisation d'un film de Nafion ® d'environ 100 nm d'épaisseur pour assurer la conductivité protonique de l'électrode, comme lors de la réalisation standard d'une électrode de pile à combustible.

### EXEMPLE 3 : PRÉPARATION DE NANOPARTICULES D'ARGENT SUR UN SUBSTRAT DE NAFION ®

Le procédé de dépôt de particules de platine décrit ci-dessus à l'exemple 1 a également été reproduit pour produire des particules d'argent (cible d'argent de pureté 99,99 %) sur un substrat de Nafion ®. Les conditions opératoires sont regroupées ci-dessous :
- Pression de l'enceinte : 40 Pa
- Densité de puissance de la décharge sur la cible : 1 W/cm²
- Caractéristiques des impulsions : * Fréquence : 100 kHz * Temps d'inversion de la polarisation 2 µs
- Dimensions de la cible d'argent 210 x 90 mm²
- Dimensions du substrat de Nafion® 50 x 50 mm²
- Distance substrat-cible 40 mm
- Temps de dépôt 5 s
- Gaz argon
- Température ambiante.

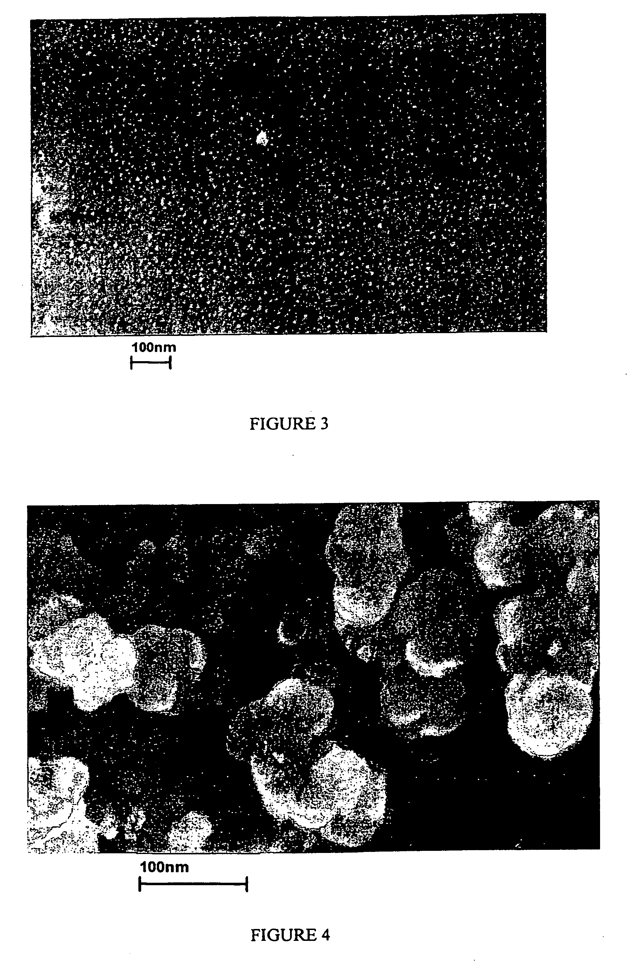

La formation des nanoparticules a été observée avec un microscope électronique à balayage équipé d'un canon à effet de champ (MEB-FEB). La figure 3 est une photographie réalisée avec un grossissement x 2.10⁵ du substrat ainsi obtenu.

Sur cette figure, on observe la formation de nanoparticules d'argent d'une taille moyenne de 10 nm. On peut observer que ces particules sont uniformément réparties sans agrégation et aucune dégradation du Nafion® n'est observée en surface. La densité surfacique ainsi que la densité des nanoparticules sont respectivement de 17 % et de 2700 particules/µm².

### EXEMPLE 4 : DÉPÔT DE NANOPARTICULES DE PLATINE SUR UN SUBSTRAT DE SILICIUM PAR LE PROCÉDÉ DE DÉPÔT « AU DÉFILÉ ».

On a réalisé un dépôt de nanoparticules de platine sur un substrat de silicium. Le dépôt a été réalisé par pulvérisation magnétron en courant pulsé d'une cible de platine (pureté 99,99%) sous atmosphère d'argon.

Le substrat avait une vitesse de défilement de 0,6m/min devant la cible de platine maintenue fixe. Les conditions opératoires sont regroupées ci-après :
- Pression de l'enceinte 30 Pa,
- Densité de puissance de la décharge sur la cible 1 W.cm⁻²,
- Caractéristique des impulsions : * Fréquence 100kHz * Temps d'inversion de la polarisation 2µs
- Dimensions de la cible 210 x 90mm²
- Dimensions du susbtrat de silicium 15x15 cm²
- Distance cible - substrat 40mm
- Vitesse de défilement 0,6m/min⁻¹
- Gaz argon
- Température ambiante

La formation des nanoparticules de platine sur le substrat de silicium a été observée avec un microscopie électronique à balayage équipé d'un canon à effet de champ (MEB-FEB).

La figure 4 est une photographie réalisée avec un grossissement x 5.10⁵ de la surface du substrat ainsi obtenu.

Sur la figure 4, on observe la formation de nanoparticules de platine d'une taille moyenne inférieure à 5nm.

On peut observer que ces nanoparticules sont uniformément réparties sans coalescence ni agrégation.

### EXEMPLE 5 : DÉPÔT DE NANOPARTICULES DE PLATINE SUR UN SUBSTRAT CONSTITUÉ D'UN TISSU DE CARBONE.

Le dépôt des nanoparticules de platine sur le substrat constitué d'un tissu de carbone a été réalisé dans les mêmes conditions qu'à l'exemple 1, avec un temps de dépôt de 5 secondes.

La formation des nanoparticules de platine a été examinée par microscopie électronique à balayage -FEG.

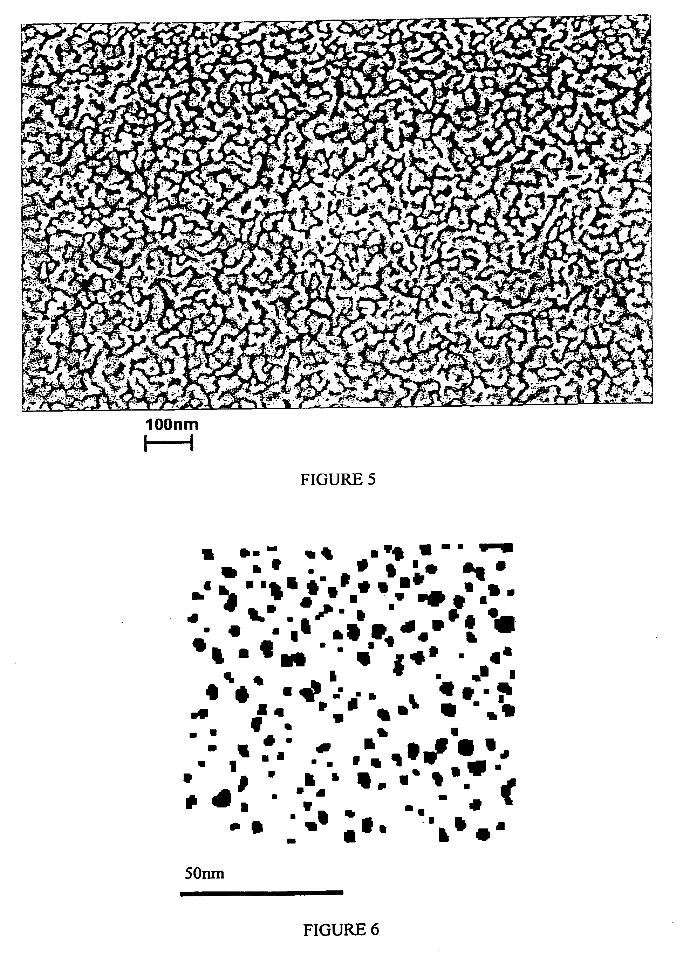

La figure 6 représente l'image binarisée obtenue à un grossissement de x 780 000.

On voit en figure 6 que les nanoparticules de platine ont une taille moyenne d'environ 3nm avec une densité de particules d'environ 15 000 nanoparticules/µm², ce qui démontre bien que l'on n'obtient pas de film continu.

### EXEMPLE COMPARATIF : DÉPÔT DE NANOPARTICULES D'ARGENT SUR UN SUBSTRAT DE SILICIUM A UNE PRESSION DE L'ENCEINTE DE 10 Pa.

On a réalisé un dépôt de nanoparticules d'argent sur un substrat de silicium. Le dépôt a été réalisé par pulvérisation magnétron en courant pulsé d'une cible d'argent (pureté 99,99 %) sous atmosphère d'argon. Les conditions opératoires sont regroupées ci-après :
- Pression de l'enceinte 10 Pa,
- Densité de puissance de la décharge sur la cible 0,5W.cm⁻²,
- Caractéristique des impulsions : * Fréquence 100kHz * Temps d'inversion de la polarisation 2µs
- Dimensions de la cible 210 x 90mm²
- Dimensions du susbtrat de silicium 5 x 5 cm²
- Distance cible - substrat 40mm
- Temps de dépôt 4s
- Gaz argon
- Température ambiante.

Les conditions opératoires utilisées à cet exemple correspondent à celles du procédé de l'invention sauf la pression qui est de 10 Pa et non pas de 15 à 60 Pa, comme dans le procédé de l'invention.

La figure 5 est une photographie en microscopie électronique à balayage (grossissement x 2.10⁵) du substrat ainsi obtenu. On voit à partir de la figure 5 que les nanoparticules d'argent ont coalescé pour former un film à la surface du substrat.

## Revendications

1. Procédé de dépôt de nanoparticules métalliques par dépôt physique en phase vapeur, ledit procédé comportant au moins une étape de pulvérisation cathodique d'un matériau métallique cible en présence d'un gaz neutre à la surface d'un substrat, dans une enceinte maintenue à une pression de 15 à 60 Pa, **caractérisé en ce que** ladite étape de pulvérisation cathodique est réalisée pendant une durée inférieure à 20 secondes.

2. Procédé selon la revendication 1, **caractérisé par le fait que** l'étape de pulvérisation cathodique est une pulvérisation cathodique magnétron.

3. Procédé selon la revendication 1 ou 2, **caractérisé par le fait que** le temps de dépôt est compris entre 2 et 20 secondes.

4. Procédé selon l'une quelconque des revendications précédentes, **caractérisé par le fait que** lors de l'étape de pulvérisation, la pression au sein de l'enceinte est maintenue à une valeur allant de 20 Pa à 40 Pa, de préférence de 30 Pa à 40 Pa.

5. Procédé selon l'une quelconque des revendications précédentes, **caractérisé par le fait que** l'étape de pulvérisation est conduite avec une densité de puissance de décharge sur la cible métallique comprise entre 0,2 W/cm² et 5 W/cm² inclusivement, de préférence entre 0,5 W/cm² et 5 W/cm² inclusivement.

6. Procédé selon la revendication 5, **caractérisé par le fait que** l'étape de pulvérisation est conduite avec une densité de puissance de décharge sur la cible métallique de 1 W/cm².

7. Procédé selon l'une quelconque des revendications précédentes, **caractérisé par le fait que** le gaz neutre utilisé pendant l'étape de pulvérisation est choisi parmi les gaz rares et leurs mélanges.

8. Procédé selon la revendication 7, **caractérisé par le fait que** le gaz rare utilisé pendant l'étape de pulvérisation est de l'argon.

9. Procédé selon l'une quelconque des revendications précédentes, **caractérisé par le fait que** l'étape de pulvérisation est effectuée à une température du substrat inférieure ou égale à 100°C.

10. Procédé selon la revendication 9, **caractérisé par le fait que** l'étape de pulvérisation est effectuée à température ambiante.

11. Procédé selon l'une quelconque des revendications précédentes, **caractérisé par le fait que** le substrat est choisi parmi le verre, le silicium, les métaux, les aciers, les céramiques telles que l'alumine, la cérine et la zircone, les tissus, les zéolithes et les polymères.

12. Procédé selon l'une quelconque des revendications précédentes, **caractérisé par le fait qu'**au sein de l'enceinte de dépôt, la distance entre la cible et le substrat est comprise entre 20 et 100 mm inclusivement.

13. Procédé selon la revendication 12, **caractérisé par le fait qu'**au sein de l'enceinte de dépôt, la distance entre la cible et le substrat est comprise entre 40 et 60 mm inclusivement.

14. Procédé selon l'une quelconque des revendications précédentes, **caractérisé par le fait que** les métaux constituant la cible métallique sont choisis parmi le platine, l'argent, l'or, le nickel, le palladium, le cuivre, le rhodium, l'iridium, le ruthénium, le chrome, le molybdène et leurs mélanges.

15. Procédé selon l'une quelconque des revendications précédentes, **caractérisé par le fait qu'**il comprend plusieurs étapes successives de dépôt de nanoparticules, lesdites étapes de dépôt utilisant des cibles métalliques de nature différente.

16. Procédé selon l'une quelconque des revendications précédentes, **caractérisé en ce que** le substrat traverse l'enceinte de dépôt à une vitesse de défilement telle que le temps de dépôt est inférieur à 20 s, de préférence compris entre 2 et 20 s.

17. Utilisation d'un substrat susceptible d'être obtenu par le procédé selon l'une quelconque des revendications précédentes, dans lequel les nanoparticules métalliques sont des nanoparticules d'argent, à titre de substrat antibactérien.

18. Utilisation d'un substrat susceptible d'être obtenu par le procédé selon l'une quelconque des revendications 1 à 16, comme matériau d'électrode pour pile à combustible.

19. Utilisation d'un substrat susceptible d'être obtenu par le procédé selon l'une quelconque des revendications 1 à 16, dans lequel les nanoparticules métalliques sont semi-conductrices, comme matériau photovoltaïque.

## Claims

1. Method for depositing metal nanoparticles by vapor phase physical deposition, said method including at least one step of cathode sputtering of a metal target in the presence of a neutral gas on the surface of a substrate in a chamber maintained at a pressure of 15 to 60 Pa, **characterized in that** said cathode sputtering step is performed for a period of less than 20 seconds.

2. Method according to claim 1, **characterized in that** the cathode sputtering step is a magnetron cathode sputtering step.

3. Method according to claim 1 or 2, **characterized in that** the deposition time is between 2 and 20 seconds.

4. Method according to any one of the preceding claims, **characterized in that** during the sputtering step the pressure in the enclosure is held at a value from 20 Pa to 4J Pa, preferably from 30 Pa to 40 Pa.

5. Method according to any one of the preceding claims, **characterized in that** the sputtering step is carried out with a discharge power density on the metal target,between 0.2 W/cm² and 5 W/cm² inclusive, preferably between 0.5 W/cm² and 5 W/cm² inclusive.

6. Method according to claim 5 **characterized in that** the sputtering step is carried out with a discharge power density on the metal target of 1 W/cm².

7. Method according to any one of the preceding claims, **characterized in that** the inert gas used during the sputtering step is selected from rare gases and mixtures thereof.

8. Method according to claim 7, **characterized in that** the rare gas used during the sputtering step is argon.

9. Method according to any one of the preceding claims, **characterized in that** the cathode sputtering step is effected at a substrate temperature less than or equal to 100 °C.

10. Method according to claim 9, **characterized in that** the sputtering step is effected at room temperature.

11. Method according to any one of the preceding claims, **characterized in that** the substrate is chosen from glass, silicon, metals, steels, ceramics such as alumina, ceria and zirconia, woven fabrics, zeolites and polymers.

12. Method according to any one of the preceding claims, **characterized in that** in the deposition enclosure the distance between the target and the substrate is between 20 and 100 mm inclusive.

13. Method according to claim 12, **characterized in that** in the deposition enclosure the distance between the target and the substrate is between 40 and 60 mm inclusive.

14. Method according to any one of the preceding claims, **characterized in that** the metals constituting the metal target are selected from platinum, silver, cold, nickel, palladium, copper, rhodium, iridium, rutherium, chromium, molybdenum and mixtures thereof.

15. Method according to any one of the preceding claims **characterized in that** it includes a plurality of successive steps of depositing nanoparticles, said deposition steps using metal targets of different kinds.

16. Method according to any one of the preceding claims, **characterized in that** the substrate passes through the deposition enclosure at a speed such that the deposition time is less than 20 s, preferably between 2 s and 20 s.

17. Use of a substrate obtainable by the method according to any one of the preceding claims, wherein the metal nanoparticles are silver nanoparticles, as an antibacterial substrate.

18. Use of a substrate obtainable by the method according to any one of claims 1 to 16 as a fuel cell electrode material.

19. Use of a substrate obtained by the method according to any one of claims 1 to 16, wherein the metal nanoparticles are semiconductors, as photovoltaic material.

## Patentansprüche

1. Verfahren zum Auftragen metallischer Nanopartikel durch physikalische Gasphasenabscheidung, wobei das genannte Verfahren mindestens einen Schritt der Kathodenzerstäubung eines metallischen Target-Werkstoffes in Anwesenheit eines Neutralgases auf die Oberfläche eines Substrates in einer Kammer umfasst, die auf einem Druck von 15 bis 60 Pa gehalten wird, **dadurch gekennzeichnet, dass** der genannte Schritt der Kathodenzerstäubung in einer Zeit von weniger als 20 Sekunden erfolgt.

2. Verfahren nach Anspruch 1, **dadurch gekennzeichnet, dass** die Kathodenzerstäubung eine Magnetron-Kathodenzerstäubung ist.

3. Verfahren nach Anspruch 1 oder 2, **dadurch gekennzeichnet, dass** die Abscheidungszeit zwischen 2 und 20 Sekunden beträgt.

4. Verfahren nach einem der vorangehenden Ansprüche, **dadurch gekennzeichnet, dass** während der Zerstäubung der Druck innerhalb der Kammer auf einem Wert gehalten wird, der von 20 Pa bis 40 Pa, vorzugsweise von 30 Pa bis 40 Pa, beträgt.

5. Verfahren nach einem der vorangehenden Ansprüche, **dadurch gekennzeichnet, dass** die Zerstäubung bei einer Leistungsdichte der Entladung am metallischen Target von 0,2 W/cm² bis einschließlich 5 W/cm², vorzugsweise von 0,5 W/cm² bis einschließlich 5 W/cm², durchgeführt wird.

6. Verfahren nach Anspruch 5, **dadurch gekennzeichnet, dass** die Zerstäubung bei einer Leistungsdichte der Entladung am metallischen Target von 1 W/cm² durchgeführt wird.

7. Verfahren nach einem der vorangehenden Ansprüche, **dadurch gekennzeichnet, dass** das während der Zerstäubung verwendete Neutralgas aus den Edelgasen und deren Gemischen ausgewählt wird.

8. Verfahren nach Anspruch 7, **dadurch gekennzeichnet, dass** das während der Zerstäubung verwendete Edelgas Argon ist.

9. Verfahren nach einem der vorangehenden Ansprüche, **dadurch gekennzeichnet, dass** die Zerstäubung bei einer Substrat-Temperatur von kleiner oder gleich 100°C erfolgt.

10. Verfahren nach Anspruch 9, **dadurch gekennzeichnet, dass** die Zerstäubung bei Umgebungstemperatur erfolgt.

11. Verfahren nach einem der vorangehenden Ansprüche, **dadurch gekennzeichnet, dass** das Substrat aus Glas, Silizium, den Metallen, Stählen, Keramiken wie Aluminiumoxid, Ceroxid und Zirkonoxid, den Geweben, Zeolithen und Polymeren ausgewählt wird.

12. Verfahren nach einem der vorangehenden Ansprüche, **dadurch gekennzeichnet, dass** der Abstand zwischen dem Target und dem Substrat im Inneren derAbscheidungskammer von 20 bis einschließlich 100 mm beträgt.

13. Verfahren nach Anspruch 12, **dadurch gekennzeichnet, dass** der Abstand zwischen dem Target und dem Substrat im Inneren der Abscheidungskammer von 40 bis einschließlich 60 mm beträgt.

14. Verfahren nach einem der vorangehenden Ansprüche, **dadurch gekennzeichnet, dass** die Metalle, die das metallische Target bilden, aus Platin, Silber, Gold, Nickel, Palladium, Kupfer, Rhodium, Iridium, Ruthenium, Chrom, Molybdän und deren Gemischen ausgewählt werden.

15. Verfahren nach einem der vorangehenden Ansprüche, **dadurch gekennzeichnet, dass** es mehrere aufeinander folgende Schritte der Abscheidung von Nanopartikeln umfasst, wobei in den genannten Abscheidungsschritten metallische Targets unterschiedlicher Beschaffenheit verwendet werden.

16. Verfahren rach einem der vorangehenden Ansprüche, **dadurch gekennzeichnet, dass** das Substrat die Abscheidungskammer mit einer solchen Durchgangsgeschwindigkeit durchquert, dass die Abscheidungszeit unter 20 s beträgt und vorzugsweise zwischen 2 und 20 s liegt.

17. Verwendung eines Substrats, erhältlich nach einem Verfahren gemäß einem der vorangehenden Ansprüche, bei dem die metallischen Nanopartikel Silber-Nanopartikel sind, als antibakterielles Substrat.

18. Verwendung eines Substrats, erhältlich nach einem Verfahren gemäß einem der Ansprüche 1 bis 16, als Elektrodenwerkstoff für Brennstoffzellen.

19. Verwendung eines Substrats, erhältlich nach einem Verfahren gemäß einem der Ansprüche 1 bis 16, bei dem die metallischen Nanopartikel halbleitend sind, als photovoltaischer Werkstoff.
